Europäisches Patentamt

European Patent Office

Office européen des brevets

(19)

(11) Publication number: **0 083 230**
**B1**

(12)

# EUROPEAN PATENT SPECIFICATION

(45) Date of publication of patent specification: **29.07.87**

(21) Application number: **82306940.6**

(22) Date of filing: **23.12.82**

(51) Int. Cl.⁴: **G 11 C 7/00, G 11 C 8/00, G 06 F 3/00, G 06 F 13/00**

(54) **Method for controlling read-out or write in of semiconductor memory device and apparatus for the same.**

(30) Priority: **29.12.81 JP 214816/81**

(43) Date of publication of application:
**06.07.83 Bulletin 83/27**

(45) Publication of the grant of the patent:
**29.07.87 Bulletin 87/31**

(84) Designated Contracting States:
**DE FR GB**

(56) References cited:
**DE-A-2 803 989**
**DE-A-2 807 616**
**DE-A-2 853 926**
**DE-A-2 942 741**
**DE-B-2 855 744**
**US-A-3 969 706**
**US-A-4 086 662**
**US-A-4 240 139**

(73) Proprietor: **FUJITSU LIMITED**
**1015, Kamikodanaka Nakahara-ku**
**Kawasaki-shi Kanagawa 211 (JP)**

(72) Inventor: **Tanaka, Miki**
**1380, Kamikodanaka Nakahara-ku**
**Kawasaki-shi Kanagawa 211 (JP)**
Inventor: **Ooami, Kazuo 10-1041,**
**Minaminagatsuda-danchi**
**3016-1 Nagatsuda-cho Midori-ku**
**Yokohama-shi Kanagawa 227 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

EP 0 083 230 B1

Courier Press, Leamington Spa, England.

# 0 083 230

## Description

The present invention relates to a method for controlling read-out or write-in of a semiconductor memory device, and an apparatus for the same.

The characteristics, for example working velocity, of a semiconductor memory device, especially a random access memory (RAM), depend on the sequence in which memory cells of the device are addressed, i.e. depend on the selection pattern.

For example, if a plurality of cells a, b, c, d, e are available to be selected many different selection patterns (addressing sequences) are possible. For example the selection pattern may be

$$"a \to b \to c \to d \to e" \text{ or } "a \to b \to e \to c \to d \to e", \text{ etc.}$$

Differences between the patterns in accordance with which memory cells are selected result in different characteristics of the semiconductor memory device.

In the preshipment test of a RAM various selection patterns are used for testing characteristics of the RAM. In such a test a cell of the memory cell array of the RAM is directly selected by a corresponding address command.

Since the memory cells of a RAM can be selected at random, all possible random selection patterns (i.e. all possible random sequences of addressing of all the memory cells of the RAM) have to be considered.

Previously, to confirm that such a memory device complies with required working characteristics for all possible selection patterns has required testing of the device with all possible random selection patterns, thus necessitating an extremely long testing time.

United States Patent No. 3 969 706 discloses a MISFET dynamic random access memory device having 4,096 cells, wherein six common address inputs are applied to a row address latch and a column address latch. The row address latch is operated by a row clock and control circuit in response to a row address strobe. The column address latch together with a data output latch and buffer are operated by a column clock and control circuit, in response to a column address strobe.

An embodiment of the present invention can provide a method by which the dependence of the working characteristics of a semiconductor memory device upon selection patterns of the memory cells is reduced, and by which the testing of the semiconductor memory device is facilitated. An embodiment of the present invention can also provide an apparatus for the same.

In accordance with a first aspect of the present invention there is provided a method for controlling the read-out or write-in of a semiconductor memory device comprising, in the selection of memory cells in the memory cell array to read out or write in data, the steps of selecting a memory cell of a specific address in the memory cell array, accessing the memory cell of the specific address, and then and only then accessing a memory cell of a designated address corresponding to externally supplied address signals.

In accordance with a second aspect of the present invention there is provided memory apparatus arranged to operate in accordance with a method of the first aspect of the invention, wherein an address latch portion, an address decoder portion, a memory cell array portion, and an output latch portion are formed and connected in order. The address latch portion receives as input an address latch clock signal, an address of a cell to be selected in the memory cell array portion (in response to externally supplied address signals), and a fixed address setting signal FAS for setting a fixed address (the specific address) corresponding to a specific cell in the memory cell array portion. It generates as output the address of the cell to be selected between downedges of the address latch clock signal, and the fixed address of the specific cell on both sides of each downedge of the clock signal. The address decoder portion decodes these addresses into respective decoded addresses. The memory cell array portion 3 outputs data stored in memory cells at the respective decoded addresses. The output latch portion 5 latches only the data from the cell to be selected.

Reference is made, by way of example, to the accompanying drawings in which:—

Fig. 1 is a block diagram for assistance in explaining an embodiment of the present invention;
Fig. 2 is a timing chart for assistance in explaining an embodiment of the present invention;
Fig. 3 is a circuit diagram of an apparatus embodying the present invention, based on Fig. 1;
Fig. 4 is a circuit diagram of an address gate portion of the apparatus of Fig. 3;
Fig. 5 is a circuit diagram of a modification of the apparatus of Fig. 3;
Fig. 6A is an explanatory drawing for explaining selection of memory cells in a known semiconductor memory device;
Fig. 6B is an explanatory drawing of the effect of the present invention.

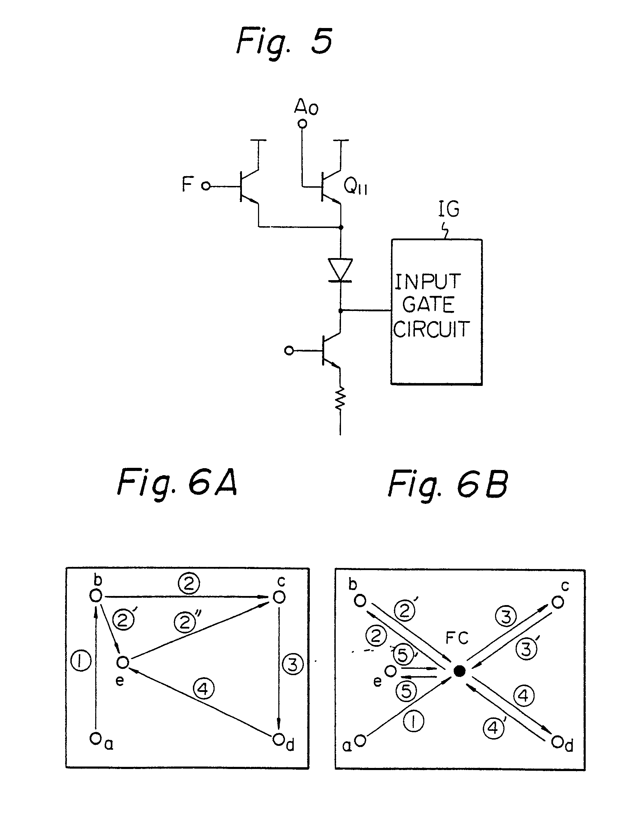

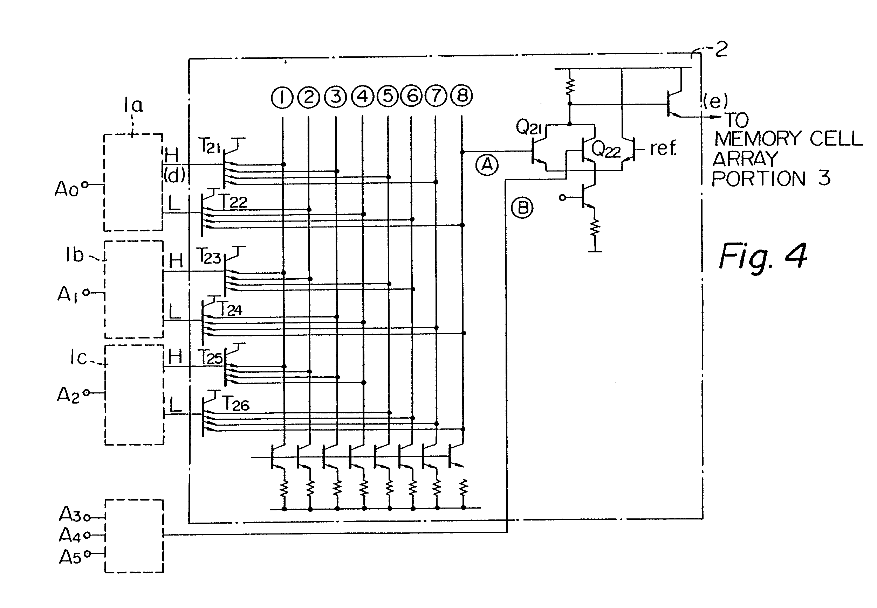

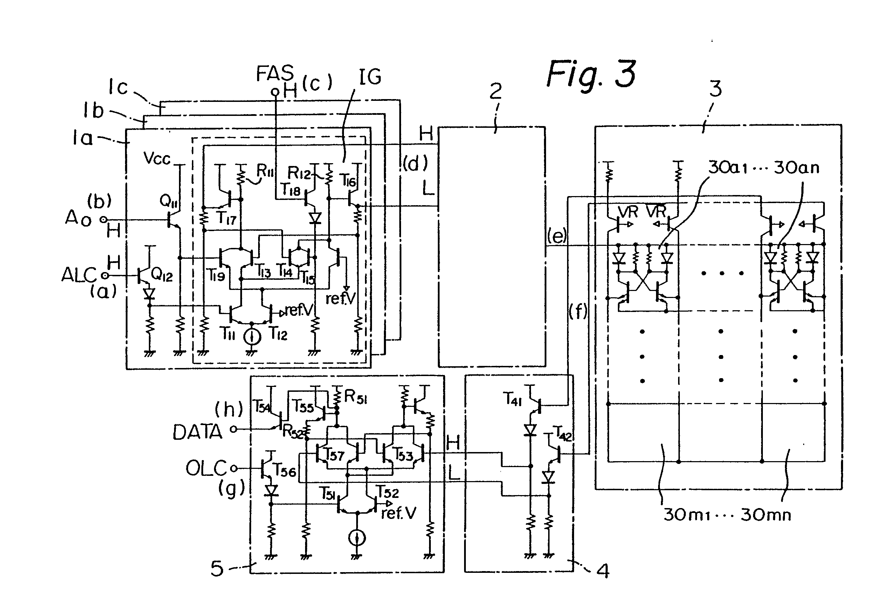

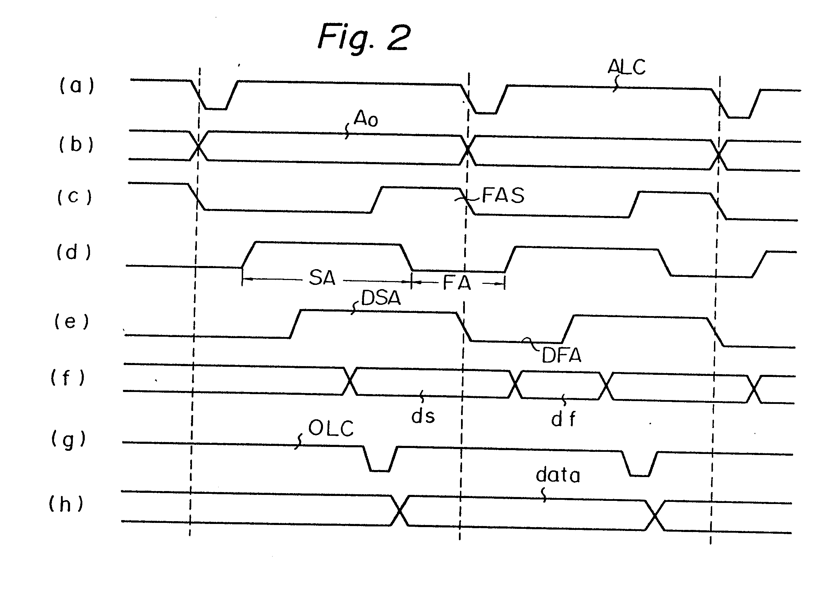

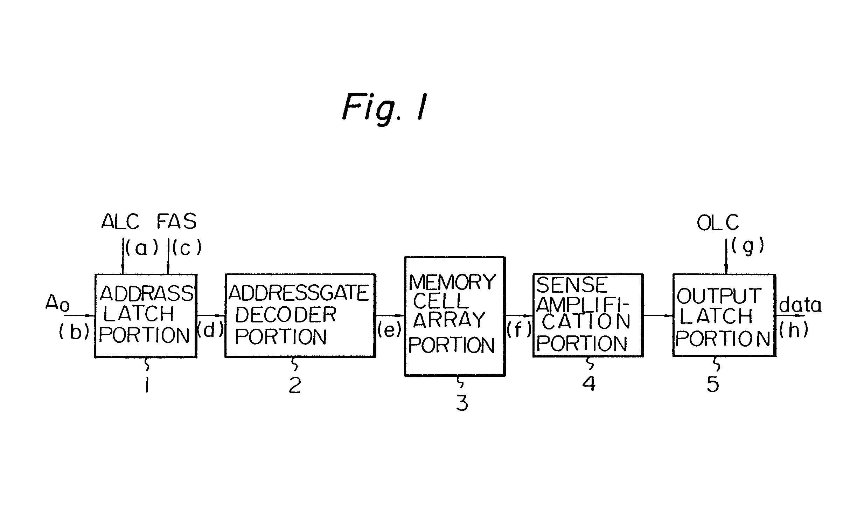

Referring to Fig. 1, 1 is an address latch portion, 2 an address gate decoder portion, 3 a memory cell array portion, 4 a sense amplification portion, and 5 an output latch portion.

The different waveforms (a) to (h) in Fig. 2 arise at points similarly labelled in Fig. 1, and in Figs. 3 and 4.

An address latch clock signal ALC (a), an address signal $A_0$ (b) corresponding to a cell to be selected in the memory cell array portion 3, and a fixed address setting signal FAS (c) for setting a fixed address corresponding to a specified cell in the memory cell array portion 3, are input to the address latch portion 1. The address latch portion 1 outputs (d) an address SA (a selection address) of the cell to be selected or a fixed address FA of the specified cell.

2

0 083 230

The address gate decoder portion 2 decodes the selection address SA and the fixed address FA and sends (e) respective corresponding decoded signals DSA and DFA to the memory cell array portion 3.

From the memory cell array portion 3 there is read out (f) data ds and df stored in memory cells corresponding to the above decoded signals DSA or DFA (i.e. the selected memory cell and the specified cell respectively). The sense amplification portion 4 amplifies the data ds and df.

The output latch portion 5 operates in accordance with an output latch clock signal OLC (g) and latches only the read-out data ds which was stored in the selected cell and generates data (h).

The operation of each portion in Fig. 1 will now be explained in more detail with reference to Figs. 3 and 4.

The address latch portion 1 as seen in Fig. 3 consists of three parts 1a, 1b, and 1c, to which the address signals $A_0$, $A_1$, and $A_2$ are input respectively (as illustrated more clearly in Fig. 4). All the parts of the address latch portion 1 operate in the same way, so only the operation of part 1a will be explained below.

When the address latch clock signal is at "L" level (low level) (and the fixed address setting signal FAS is at "L" level—see Fig. 2, (a) and (c)) the latch part 1a adopts a state depending upon the address signal $A_0$ (see Fig. 2, (b)) and outputs a selection address part accordingly (see SA Fig. 2(d)).

Subsequently, while the address latch clock signal ALC is at the "H" level (and FAS is at "L" level) the previously adopted state is kept. That is, referring to Fig. 3, when a high ("H") level signal ALC is applied to the base of a transistor $Q_{12}$, the base potential of a current switching transistor $T_{11}$ is higher than that of a current switching transistor $T_{12}$ in an input gate circuit IG. Therefore, $T_{11}$ turns on, but $T_{12}$ turns off. Under these circumstances a transistor $T_{19}$ (to a base of which an address signal $A_0$ is applied via a transistor $Q_{11}$) is off, so that any change in address signal $A_0$ has no effect on the state of the address latch part 1a. Thus, SA is sent (d) to the address gate decoder portion 2 from part 1a.

Now, when the fixed address setting signal FAS is input (at "H" level), a switch $T_{15}$ is turned on, so current passes through a resistor $R_{12}$ and $T_{15}$ and $T_{11}$. Therefore, the lower terminal of the resistor $R_{12}$ takes an "L" level and the lower terminal of a resistor $R_{11}$ takes an "H" level. This is so regardless of the previous state of the latch part 1a. Thus the address part output by 1a corresponds to the fixed address FA. Thus, the fixed address FA is sent (d) to the address gate decoder portion 2.

Therefore, for each downedge of the clock signal ALC as shown in Fig. 2(a), a selected address signal $A_0$ and the fixed address setting signal FAS are each applied to the part 1a, as shown in Figs. 2(b) and (c). $A_0$ and FAS are latched to produce the output of the address latch portion as shown in Fig. 2(d), whereby SA is present in an interval between one edge (downedge) and the next edge (downedge) of the clock signal ALC, and FA is present for a time interval at both sides of the downedge of the clock signal ALC. Thus SA and FA appear sequentially, as shown in Fig. 2(d).

Details of the address gate decoder portion 2 are shown in Fig. 4.

As will be understood from Fig. 3, SA and FA are sent from latch part 1a along two output lines (connected to transistors $T_{16}$ and $T_{17}$, and hence the lower terminals of $R_{12}$ and $R_{11}$ respectively) which carry complementary ("H" and "L") levels.

The two output lines are connected to the bases of multiemitter transistors $T_{21}$ and $T_{22}$ of the address gate decoder portion 2, respectively. Emitters of the transistors $T_{21}$ and $T_{22}$ are selectively connected to lines ① to ⑧ of the address gate decoder portion as shown in Fig. 4.

The output lines of the other parts 1b and 1c are connected to the address gate decoder portion in a similar way, but to different selections of the lines ① to ⑧ as shown in Fig. 4.

Each of lines ① to ⑧ is clamped to the "H" level in the event that an "H" level signal is applied to that line at any one point along it.

In the case of the illustrated embodiment of this invention, at least one "H" level signal is applied to each of lines ① to ⑦ but only "L" level signals are applied to line ⑧ in correspondence to the fixed address FA. Thus, each of lines ① to ⑦ is clamped to the "H" level and only line ⑧ is clamped to the "L" level. Line ⑧ is connected to the base of a transistor $Q_{21}$ through a line Ⓐ, and the other lines ① to ⑦ are connected, respectively, to bases of other transistors of the same type as transistor $Q_{21}$, whose illustration is omitted to simplify Fig. 4.

The address gate decoder portion similarly is operable to decode three address signals $A_0$, $A_1$, and $A_2$ to select any one of 8 lines by a known method.

Decoded signals DSA and DFA are sent (e) to the memory cell array portion 3 as shown in Fig. 4.

If another three address signals $A_3$, $A_4$, and $A_5$ exist, these are decoded through a line Ⓑ by other parts corresponding to 1a, 1b and 1c, in the same way as above.

Referring to Fig. 3, the memory cell array portion 3 consists of cells forming m columns and n rows.

Data ds and df stored in the memory cells corresponding to the addresses DSA and DFA input to the memory cell array portion 3 are read out in turn as shown at (f) in Figs. 2 and 3. The data ds and df are amplified by transistors $T_{41}$ and $T_{42}$ of the sense amplification portion 4 and are sent to the output latch portion 5.

As will be understood from Fig. 3, read-out data is sent from the memory cell array portion along two lines, to $T_{41}$ and $T_{42}$ respectively, which carry complementary levels. The sense amplification portion delivers amplified data to the output latch portion along two lines which carry complementary ("H" and "L") levels.

An output latch clock signal OLC is applied to the base of a transistor $T_{56}$ in the output latch portion 5.

3

OLC is usually at the "H" level but drops to the "L" level for a short time, when data ds is being sent from the sense amplification portion (see Fig. 2, (f) and (g)). When OLC is at "L" level, a current switching transistor $T_{51}$ turns off, but another current switching transistor $T_{52}$ turns on. In these circumstances current can pass through either of transistors $T_{57}$ and $T_{53}$ whose bases receive the respective complementary levels of the two lines from the sense amplification portion 4. In accordance with those levels (i.e. in accordance with ds) one or other of $T_{57}$ and $T_{53}$ turns on, whilst the other turns off.

For example, when an "H" level signal from the sense amplification portion 4 is applied to the base of a transistor $T_{53}$, but an "L" level signal therefrom is applied to the base of a transistor $T_{57}$, the transistor $T_{57}$ turns off and the lower terminal of a resistor $R_{51}$ is then at the "H" level.

When OLC is at "H" level, current switching transistor $T_{52}$ is off. $T_{57}$ and $T_{53}$ cannot pass current so there is no response to any change in the levels of the two lines from the sense amplification portion 4. Thus, there is no response to df. $T_{51}$ is on and maintains the state of the output latch portion established when OLC was at "L" level.

The result is that amplified data ds is output on an output transistor $T_{54}$, as shown in (h) in Figs. 2 and 3. In this manner, the output latch clock OLC enables the output latch portion 5 to latch the data ds stored in the memory cell array portion 3, so as to output only the data ds and not the data df.

Fig. 5 refers to a modification of the embodiment of this invention.

In this modification, after the address signal $A_0$ is input, the fixed address is sent to an input gate circuit IG by turning a fixed address setting signal F to the "H" level. The operation thereafter is the same as that of part 1a in Fig. 3 and will therefore be omitted.

The effect of the present invention will now be explained with reference to Figs. 6A and 6B.

Previously, as explained above, cells a, b, c, d, and e could be selected in accordance with many different selection patterns, for example a pattern as shown by arrows ①, ②, ③, and ④ or a pattern as shown by arrows ①, ②', ②", ③, and ④ in Fig. 6A. However, in accordance with the present invention, after the cell a is selected, the specified cell FC having the fixed address is addressed (see arrow ①), after the cell FC, the cell b is selected (see arrow ②) and the cell FC is then addressed again (see arrow ②'). In this way, the specified cell FC is addressed always between the cells a and b, b and c, c and d, d and e.

Therefore, according to this invention, as the cells a, b, c, d, and e are always selected through the specified cell FC, the dependence of the working characteristics of the memory device on the selection pattern of the memory cell is reduced. Moreover, all the selection patterns which have to be considered are tested by accessing (selecting) all cells once only during each access, and the efficiency of testing of the memory device is improved.

**Claims**

1. A method of operating a semiconductor memory device, for carrying out reading or writing operations in which memory cells of the device are selected in accordance with externally supplied memory addressing signals and accessed, characterised in that between every two consecutive accesses to such selected memory cells, a predetermined, fixed memory cell of the device is accessed.

2. A method as claimed in claim 1, wherein the predetermined memory cell is designated for each access thereto without the employment of externally supplied addressing signals corresponding to that cell.

3. Memory apparatus arranged to operate in accordance with claim 1 and comprising an address latch portion (1), an address decoder portion (2), a memory cell array portion (3), and an output latch portion (5), connected in order,

said address latch portion (1) being arranged to receive an address latch clock signal (ALC), and an externally supplied memory addressing signal ($A_0$ to $A_3$) corresponding to a memory cell to be selected, characterised in that the address latch portion (1) is also arranged to receive a fixed address setting signal (FAS) for setting the address (FA) of a predetermined, fixed memory cell, and to generate the address (SA) of the memory cell to be selected, between downedges of the clock signal (ALC), and to generate the fixed address (FA) of the fixed memory cell, on both sides of each downedge of the clock signal (ALC);

said address decoder portion (2) decoding the addresses (SA, FA) generated by the address latch portion (1) into respective decoded addresses (DSA, DFA);

said memory cell array portion (3) comprising means for outputting data (ds, df) stored in the cell to be selected, and the fixed cell; and

said output latch portion (5) latching only data stored in the cell to be selected.

4. Memory apparatus as claimed in claim 3, further comprising means for generating the fixed address signal (FAS) without the employment of externally supplied addressing signals corresponding to the fixed memory cell.

**Patentansprüche**

1. Verfahren zum Betrieb einer Halbleiterspeichervorrichtung, zur Durchführung von Lese- oder Schreiboperationen, bei welchem die Speicherzellen der Vorrichtung in Übereinstimmung mit von außen zugeführten Speicheradressensignalen ausgewählt und zu ihnen zugegriffen wird, dadurch gekennzeichnet, daß jeweils zwischen zwei aufeinanderfolgenden Zugriffen zu solchen ausgewählten Speicherzellen zu einer vorbestimmten, fixierten Speicherzelle der Vorrichtung zugegriffen wird.

2. Verfahren nach Anspruch 1, bei dem die vorbestimmte Speicherzelle für jeden Zugriff zu ihr ohne Verwendung von von außen zugeführten Adressensignalen, die jener Zelle entsprechen, bestimmt wird.

3. Speichervorrichtung, die zum Betrieb nach Anspruch 1 und 2 ausgelegt ist und einen Adressenverriegelungsabschnitt (1), einen Adressendekoderabschnitt (2) und einen Speicherzellenarrayabschnitt (3) und einen Ausgangsverriegelungsabschnitt (5) umfaßt, die miteinander verbunden sind, damit
der genannte Adressenverriegelungsabschnitt (1) zum Empfang eines Adressenverriegelungstaktsignals (ALC) und eines von außen zugeführten Speicheradressensignals ($A_0$ bis $A_3$), das einer auszuwählenden Speicherzelle entspricht, angeordnet ist, dadurch gekennzeichnet, daß der Adressenverriegelungsabschnitt (1) auch angeordnet ist, um ein fixiertes Adresseneinstellsignal (FAS) zum Einstellen der Adresse (FA) einer vorbestimmten fixierten Speicherzelle zu empfangen, und um die Adresse (SA) der auszuwählenden Speicherzelle zu erzeugen, zwischen Unterkanten des Taktsignals (ALC), und um die fest Adresse (FA) der fixierten Speicherzelle auf beiden Seiten von jeder Unterkante des Taktsignals (ALC) zu erzeugen;
der Adressendekoderabschnitt (2) die Adressen (SA, FA), die durch den Adressenverriegelungsabschnitt (1) erzeugt werden, in entsprechende dekodierte Adressen (DSA, DFA) dekodiert;
der genannte Speicherzellenarrayabschnitt (3) Einrichtungen zum Ausgeben von Daten (ds, df) umfaßt, die in der auszuwählenden Zelle und der fixierten Zelle gespeichert sind; und
der genannte Ausgangsverriegelungsabschnitt (5) nur Daten verriegelt, die in der auszuwählenden Zelle gespeichert sind.

4. Speichervorrichtung nach Anspruch 3, ferner mit Einrichtungen zur Erzeugung des fixierten Adressensignals (FAS) ohne Verwendung von von außen zugeführten Adressensignalen, die der fixierten Speicherzelle entsprechen.

**Revendications**

1. Procédé pour faire fonctionner un dispositif de mémoire à semiconducteur, pour exécuter des opérations de lecture ou d'écriture, dans lequel des cellules de mémoire du dispositif sont sélectionnées conformément à des signaux d'adressage de mémoire fournis extérieurement et auxquelles on a accès, caractérisé en ce qu'entre chaque groupe de deux accès consécutifs à ces cellules de mémoire sélectionnées, on a accès à une cellule de mémoire fixe prédéterminée du dispositif.

2. Procédé selon la revendication 1, dans lequel la cellule de mémoire prédéterminée est indiquée pour chaque accès à celle-ci sans utiliser les signaux d'adressage fournis extérieurement qui correspondent à cette cellule.

3. Dispositif de mémoire agencé pour fonctionner selon la revendication 1 et comprenant une partie de verrou d'adresse (1), une partie de décodeur d'adresse (2), une partie de matrice de cellules de mémoire (3), et une partie de verrou de sortie (5), connectées dans l'ordre,
la partie de verrou d'adresse (1) étant agencée pour recevoir un signal d'horloge de verrou d'adresse (ALC) et un signal d'adressage de mémoire fourni extérieurement ($A_0$ à $A_3$) correspondant à une cellule de mémoire à sélectionner, caractérisé en ce que la partie de verrou d'adresse (1) est également agencée pour recevoir un signal d'établissement d'adresse fixe (FAS) pour établir l'adresse (FA) d'une cellule de mémoire fixe prédéterminée, et pour engendrer l'adresse (SA) de la cellule de mémoire à sélectionner, entre des bords décroissants du signal d'horloge (ALC), et pour engendrer l'adresse fixe (FA) de la cellule de mémoire fixe, des deux côtés de chaque bord décroissant du signal d'horloge (ALC);
la partie de décodeur d'adresse (2) décodant les adresses (SA, FA) engendrées par la partie de verrou d'adresse (1) en adresses décodées respectives (DSA, DFA);
la partie de matrice de cellules de mémoire (3) comprenant des moyens pour engendrer en sortie des données (ds, df) mémorisées dans la cellule à sélectionner, et dans la cellule fixe; et
la partie de verrou de sortie (5) ne verrouillant que la donnée mémorisée dans la cellule à sélectionner.

4. Dispositif de mémoire selon la revendication 3, comprenant en outre un moyen pour engendrer le signal d'adresse fixe (FAS) sans utiliser les signaux d'adressage fournis extérieurement qui correspondent à la cellule de mémoire fixe.

# Fig. 5

Ao

F o  Q₁₁

IG

INPUT
GATE
CIRCUIT

# Fig. 6A

# Fig. 6B

Fig. 4

0 083 230

Fig. 3

0 083 230

Fig. 2

0 083 230

# Fig. 1

ALC  FAS
|(a) |(c)

$A_0$ ──→ | ADDRASS LATCH PORTION | (d) | ADDRESSGATE DECODER PORTION | (e) | MEMORY CELL ARRAY PORTION | (f) | SENSE AMPLIFI- CATION PORTION |──→| OUTPUT LATCH PORTION | data
(b) ──────── ──── ──── ──── ──── (h)

OLC
|(g)

1    2    3    4    5